# FASCICULE DE BREVET EUROPEEN

(11) **EP 1 075 878 B1**
(45) Date de publication et mention de la délivrance du brevet: **12.11.2003**
(21) Numéro de dépôt: 00410075.6
(22) Date de dépôt: 12.07.2000
(51) Int. Cl.: B08B 3/10

(54) **Bac de rincage à liquide ultra propre**
Spülgefäss mit äusserst reiner Flüssigkeit
Flushing vessel with ultra-clean liquid

(30) Priorité: 12.08.1999 FR 9910532
(43) Date de publication de la demande: 14.02.2001
(73) Titulaire: Vaco Microtechnologies, 38760 Varces Allières et Risset (FR)
(72) Inventeur: Oravec, Victoria, 38000 Grenoble (FR)
(74) Mandataire: Hecké, Gérard

(56) Documents cités:
- US-A- 5 698 038
- PATENT ABSTRACTS OF JAPAN vol. 018, no. 507 (E-1609), 22 septembre 1994 (1994-09-22) -& JP 06 177104 A (FUJI ELECTRIC CO LTD), 24 juin 1994 (1994-06-24)

## Description

### Domaine technique de l'invention

L'invention est relative à un bac de rinçage à liquide ultra propre, comprenant une chambre de rinçage délimitée par une enveloppe équipée à la partie inférieure d'un dispositif diffuseur à fond perforé connecté à un premier réseau d'alimentation de liquide pressurisé, et d'une goulotte de débordement à la partie supérieure pour la réception du liquide de rinçage chargé de particules ou de contaminants enlevés des objets à rincer.

### Etat de la technique

Un premier type de bac de rinçage connu fonctionne par débordement grâce à la présence d'un déversoir à la partie supérieure du bac. La chambre de rinçage est remplie par de l'eau déionisée ultra propre jusqu'au niveau du déversoir. Le remplissage s'effectue par l'intermédiaire d'une tubulure d'arrivée d'eau située dans la partie centrale du fond du bac. L'eau s'écoule par débordement dans le déversoir, et est évacuée par une canalisation de sortie. Le rinçage des substrats contenus dans le panier à l'intérieur de la chambre de rinçage s'opère par un simple effet de remplissage du bac. La figure 3 du document US-A-5485861 décrit un tel dispositif qui nécessite un volume important d'eau déonisée. L'effet de turbulence créé dans la chambre de rinçage lors de la montée de l'eau perturbe la circulation uniforme de l'eau, au détriment des caractéristiques de nettoyage.

Le document US-A-5698038 décrit un bac de rinçage conformément au préambule de la revendication 1 comprenant des jets de re-circurlation disposés à la périphérie du fond de la cuve permettant de déplacer les particules qui se sont accumulées dans le fond de la cuve vers la partie supérieure de la cuve et de les évacuer par le déversoir.

Un troisième type de bac de rinçage connu fonctionne par vidange rapide grâce à la présence d'une trappe dans le fond du bac. Le bac est d'abord rempli d'eau déionisée, puis est vidangé par gravité après ouverture de la trappe amovible. La vitesse élevée d'écoulement de l'eau vers le bas entraîne les éléments contaminants présents sur les substrats. Ce type de bac nécessite également une consommation importante d'eau déionisée.

Le document US-A-5485861 montre aux figures 1 et 2 un dispositif analogue, mais l'évacuation de l'eau intervient à travers des trous ménagés dans le fond du bac lequel est raccordé à la tubulure de sortie.

Dans le document JP-A-06177104, un élément de guidage de l'eau formant un angle aigu avec les parois de la cuve de rinçage, permet de faire circuler l'eau de la partie centrale vers la partie supérieure de la cuve de rinçage.

### Objet de l'invention

L'objet de l'invention consiste à réaliser un bac de rinçage à liquide ultra propre permettant d'obtenir un rinçage optimum des objets contenus dans le bac avec une consommation de liquide réduite.

Ce but est atteint par un bac de rinçage selon les revendications annexées. Les objets à rincer sont constitués par des substrats couramment rencontrés dans les industries du semi-conducteur, des micro-systèmes et des écrans plats, notamment à base de silicium, AsGa, germanium, quartz, verre, etc...,lesquels sont rangés parallèlement dans un panier à l'intérieur de la chambre de rinçage.

Selon une autre caractéristique de l'invention, des antennes mégasoniques se trouvent sous la plaque de fond pour engendrer des vibrations acoustiques dans le liquide de rinçage.

### Description sommaire des dessins

D'autres avantages et caractéristiques ressortiront plus clairement de la description qui va suivre d'un mode de réalisation de l'invention donné à titre d'exemple non limitatif, et représenté aux dessins annexés, dans lesquels:
- la figure 1 est vue en coupe du bac de rinçage selon l'invention ;
- la figure 2 montre une vue en perspective du dispositif diffuseur agencé à la base du bac de la figure 1 ;
- la figure 3 est une vue en plan de la figure 2 ;
- les figures 4 et 5 représentent des vues en coupe selon les lignes 4-4 et 5-5 de la figure 3 ;
- la figure 6 illustre le principe de fonctionnement du bac de rinçage de la figure 1 ;
- la figure 7 est une vue identique de la figure 1 illustrant une variante de réalisation du bac de rinçage ;
- la figure 8 montre une vue en coupe du système d'alimentation en eau du du bac de rinçage de la figure 7 ;
- la figure 9 est une vue en plan du fond diffuseur de la figure 7.

### Description de deux modes de réalisation préférentiels

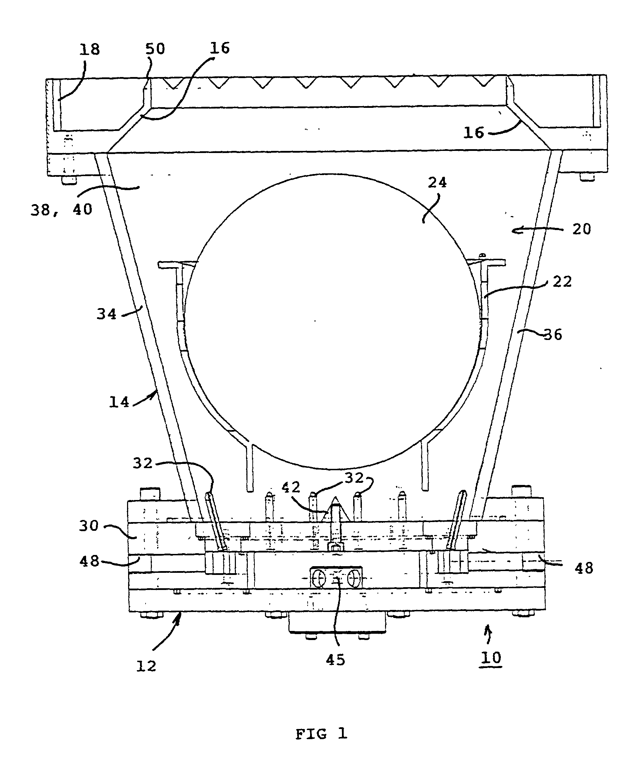

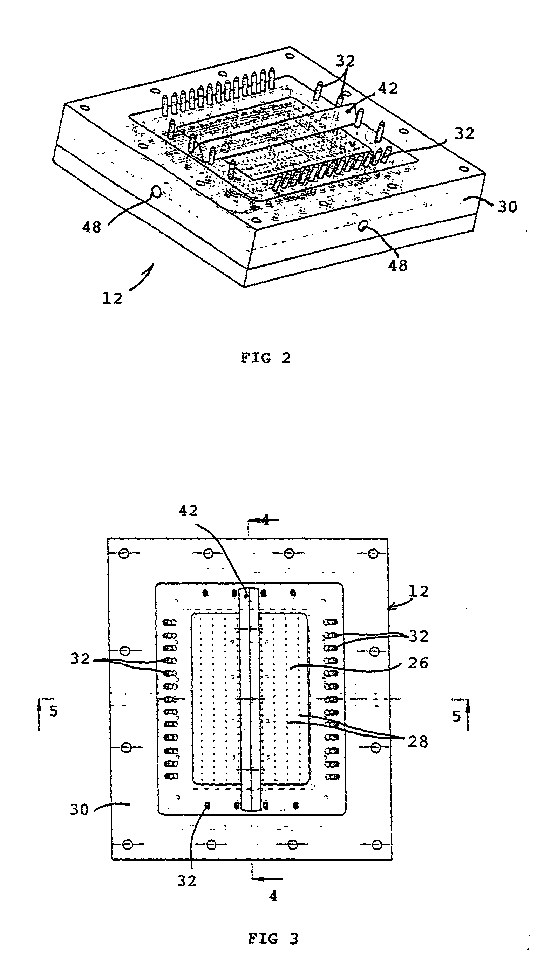

En référence aux figures 1 à 5, le bac de rinçage 10 comporte à la base un dispositif diffuseur 12 de liquide ultra propre, par exemple d'eau déionisée, auquel est raccordée une enveloppe 14 équipée à la partie supérieure d'un déflecteur 16 et d'une goulotte de débordement 18. A l'intérieur de la chambre de rinçage 20 délimitée par l'enveloppe 14 se trouve un panier 22 de rangement des substrats 24 à rincer.

Le dispositif diffuseur 12 d'eau est composé d'un fond 26 perforé de plusieurs rangées de trous 28 placés sous le panier 22, et d'une bride 30 périphérique portant une pluralité de buses 32 de projection d'eau. L'enveloppe 14 est dotée de deux faces latérales 34, 36 inclinées selon un angle prédéterminé, et réunies à deux faces verticales parallèles 38, 40. Les buses 32 sont échelonnées le long de la bride 30 en s'étendant dans la direction des quatre faces 34, 36, 38, 40 du bac. Selon le type de chambre de rinçage, les buses 32 situées du côté des faces 38, 40 peuvent être supprimées.

Un élément déviateur 42 en forme de divergent est fixé sur le fond 26 pour orienter les flux descendants vers les côtés inclinés du bac de rinçage 10. L'élément déviateur 42 de forme prismatique s'étend dans la partie centrale du fond 26 et parallèlement aux deux faces latérales 34, 36. La base du prisme prend appui sur le fond, et le sommet est orienté vers la base du panier 22.

Un premier réseau d'alimentation 44 en eau est raccordé à au moins un orifice d'admission 45 connecté au fond 26, et un deuxième réseau d'alimentation 46 en eau est branché à des orifices d'admission 48 en liaison avec les buses 32 de la bride 30.

Le déflecteur 16 fait partie intégrante de la face interne de la goulotte de débordement 18, et constitue un convergent formant un angle obtus avec les faces latérales 34, 36 de l'enveloppe 14. Le déflecteur 16 sert à orienter les flux ascendants en provenance des buses 32 vers le centre de la chambre de rinçage 20 selon un mouvement circulaire de haut en bas.

La goulotte de débordement 18 reçoit l'eau usée de rinçage, et est reliée par une tubulure soit vers l'égout, soit vers une installation de recyclage.

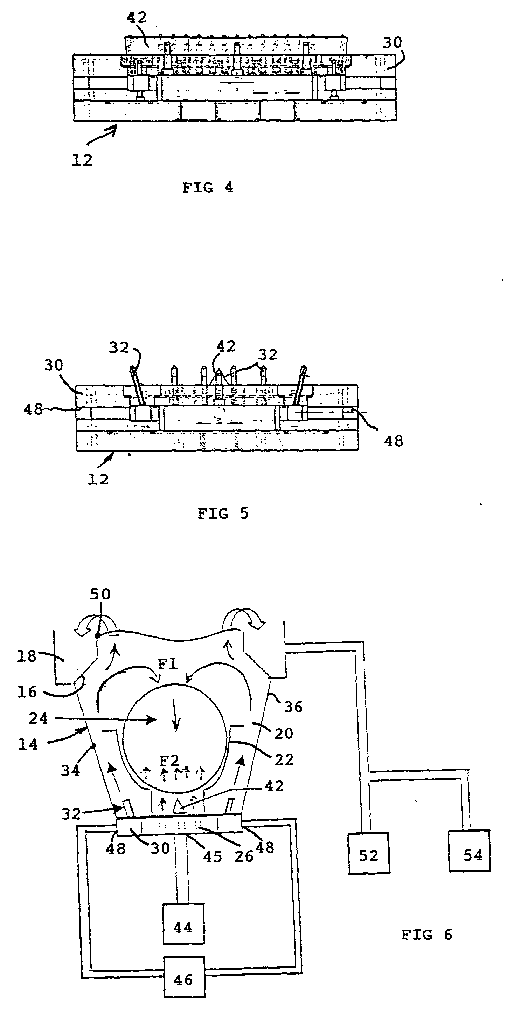

Le cycle de rinçage est illustré sur la figure 6, et s'effectue de la manière suivante :

La chambre de rinçage 20 est remplie en permanence de liquide ultra propre, par exemple de l'eau, jusqu'au déversoir 50 de la goulotte 18 grâce à un faible débit d'eau en provenance à la fois des trous 28 du fond perforé 26 du premier réseau d'alimentation 44, et des buses 32 du deuxième réseau d'alimentation 46. Avant l'introduction du panier 22 contenant les substrats 24 à rincer, le débit des buses 32 ou du fond 26 est augmenté pour renouveler la surface de l'eau en éliminant toute particule de poussière et d'impureté.

Le panier 22 avec les substrats 24 est ensuite introduit dans la chambre de rinçage 20, suivi de l'ouverture de la première vanne d'alimentation des buses 32 pour obtenir un débit d'eau prédéterminé en sortie des buses 32 latérales. Les jets d'eau suivent les parois internes des faces latérales 34, 36, 38, 40 de l'enveloppe 14, et sont déviés dans la partie supérieure par le déflecteur 16 convergent en créant des écoulements circulatoires suivant les flèches F1. Il en résulte une circulation d'eau de haut en bas apte à décoller les contaminants et particules présents à la surface des substrats 24.

Les contaminants et particules décollés se retrouvent dans le liquide de rinçage. Après un temps de rinçage de l'ordre de plus ou moins une minute, la première vanne d'alimentation des buses 32 est fermée, et on ouvre ensuite la deuxième vanne d'alimentation du fond perforé 26 permettant l'injection d'eau propre pressurisée par le bas. Le mouvement de l'eau est alors inversé grâce à l'effet de piston hydraulique qui chasse l'eau usée contenant les contaminants dans le sens ascendant de la flèche F2. L'eau usée se déverse dans la goulotte de débordement 18, d'où elle est évacuée vers l'égout 52.

Après un certain temps de rinçage par le fond perforé 26 du premier réseau d'eau d'alimentation 44, la deuxième vanne d'alimentation est fermée, et on recommence le même processus pendant un ou plusieurs cycles additionnels.

A la fin du rinçage par effet de piston hydraulique, on retire le panier 22 avec les substrats 24 propres. Le bac de rinçage 10 est à nouveau alimenté sous un faible débit de liquide de rinçage en attendant un nouveau cycle de rinçage de substrats. L'eau contaminée peut éventuellement être évacuée vers la station d'eau 54 déionisée pour être recyclée.

Les mouvements alternés du liquide provoqués par les buses 32 du deuxième réseau 46, et par l'effet piston hydraulique dû au fond perforé 26 du premier réseau 44, permettent d'obtenir un rinçage optimum avec une consommation de liquide très réduite et une durée de cycle courte.

Il est clair que le cycle de rinçage peut être inversé, en utilisant l'effet piston hydraulique en premier, suivi de la recirculation. Il est également possible d'utiliser les injecteurs périphériques lors du renouvellement de l'eau par l'effet de piston.

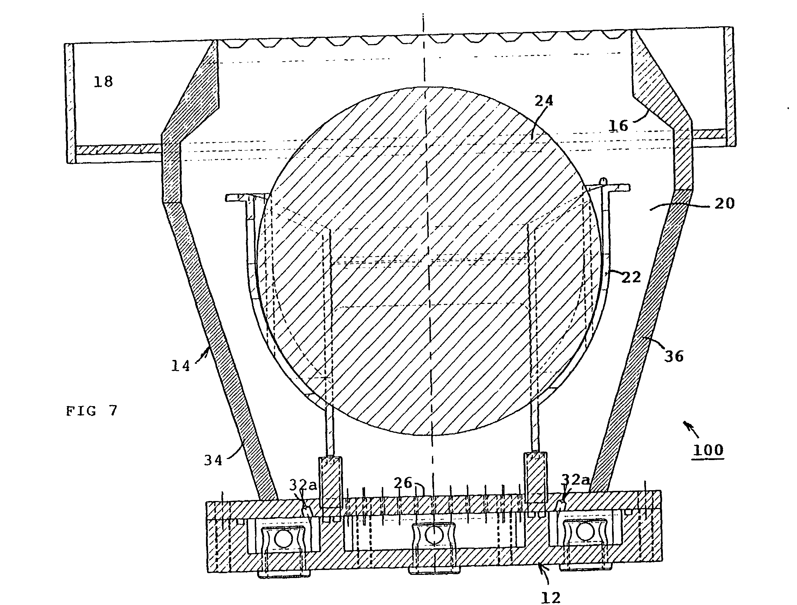

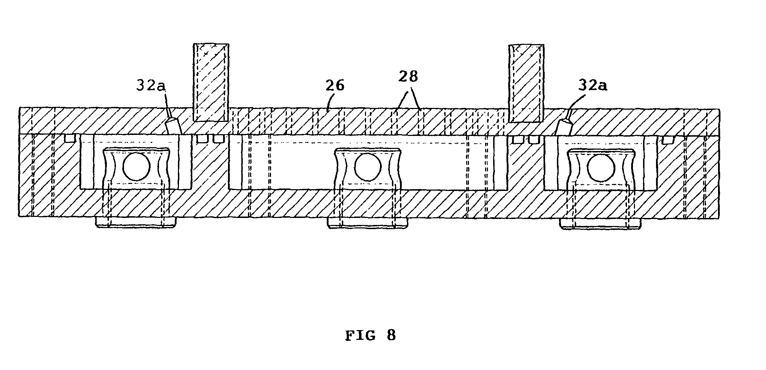

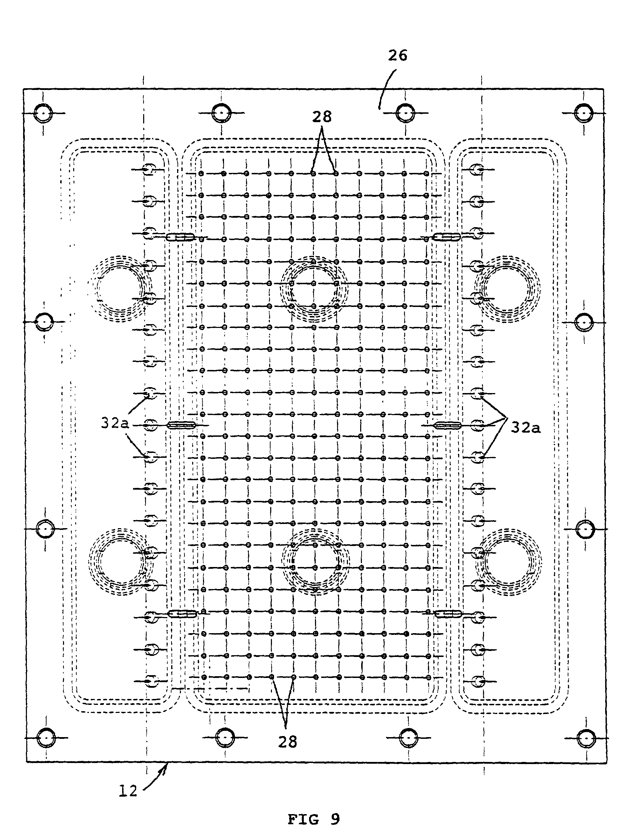

Sur la variante du bac de rinçage 100 des figures 7 à 9, les buses 32 sont supprimées dans le fond 26, et remplacées par des injecteurs 32a constitués par de simples orifices calibrés en liaison avec le deuxième réseau d'alimentation 46. L'élément déviateur 42 est également supprimé dans la partie centrale du fond 26 diffuseur.

## Revendications

1. Bac de rinçage à liquide ultra propre comprenant :
- une chambre de rinçage (20) délimitée par une enveloppe (14) équipée à la partie inférieure d'un dispositif diffuseur (12) à fond perforé (26) connecté à un premier réseau d'alimentation (44) de liquide pressurisé, et d'une goulotte de débordement (18) à la partie supérieure pour la réception du liquide de rinçage chargé de particules ou de contaminants enlevés des objets à rincer,
- une pluralité de moyens de projection (32, 32a) en liaison avec un deuxième réseau d'alimentation (46) de liquide pressurisé, répartis à la périphérie du fond perforé (26) du dispositif diffuseur (12),
- des moyens contrôlant alternativement l'alimentation des moyens de projection (32, 32a) par le deuxième réseau d'alimentation (46) et du dispositif diffuseur (12) par le premier réseau d'alimentation (44), bac de rinçage **caractérisé en ce que** la chambre de rinçage (20) comporte, en plus, un déflecteur (16) disposé à l'extrémité supérieure des faces latérales (34, 36) de l'enveloppe (14), en direction de la partie centrale de la chambre de rinçage (20) et formant un angle obtus avec les faces latérales (34, 36) de l'enveloppe (14) qui s'étendent entre le fond (26) et le déflecteur (16).

2. Bac de rinçage selon la revendication 1, **caractérisé en ce que** le déflecteur (16) constitue la face interne de la goulotte de débordement (18).

3. Bac de rinçage selon l'une des revendications 1 et 2, **caractérisé en ce que** les faces latérales (34, 36) forment un angle obtus avec le fond perforé (26).

4. Bac de rinçage selon l'une quelconque des revendications 1 à 3, **caractérisé en ce que** les moyens de projection sont formés par des buses (32) ou des injecteurs (32a), orientés sensiblement parallèlement aux faces latérales (34, 36).

5. Bac de rinçage selon l'une quelconque des revendications 1 à 4, **caractérisé en ce que** le fond (26) du dispositif diffuseur (12) porte un élément déviateur (42) disposé dans la partie centrale du fond (26).

6. Bac de rinçage selon la revendication 5, **caractérisé en ce que** l'élément déviateur (42) présente une forme prismatique, dont la base prend appui sur le fond, et le sommet est orienté vers les objets à rincer.

## Patentansprüche

1. Spülgefäss mit Reinstflüssigkeit, das umfasst:
- eine Spülkammer (20), die von einer Einfassung (14) begrenzt wird, die im unteren Bereich mit einer Verteilvorrichtung (12) mit durchbrochenem Boden (26), der mit einem ersten Versorgungsnetz (44) für Druckflüssigkeit verbunden ist, und in ihrem oberen Bereich mit einer Überlaufschurre (18) zur Aufnahme der mit von den zu spülenden Gegenständen entfernten Partikeln oder Schadstoffen beladenen Spülflüssigkeit versehen ist,
- eine Mehrzahl von Spritzvorrichtungen (32, 32a) in Verbindung mit einem zweiten Versorgungsnetz (46) für Druckflüssigkeit, die am Umfang des durchbrochenen Bodens (26) der Verteilvorrichtung (12) verteilt sind,
- Vorrichtungen zur abwechselnden Steuerung der Versorgung der Spritzvorrichtungen (32, 32a) durch das zweite Versorgungsnetz (46) und der Verteilvorrichtung (12) durch das erste Versorgungsnetz (44), Spülgefäss, das **dadurch gekennzeichnet ist, dass** die Spülkammer (20) ferner ein Ablenkelement (16) umfasst, das am oberen Ende der Seitenflächen (34, 36) der Einfassung (14) in Richtung auf den zentralen Bereich der Spülkammer (20) angeordnet ist und einen stumpfen Winkel mit den Seitenflächen (34, 36) der Einfassung (14) bildet, die sich zwischen dem Boden (26) und dem Ablenkelement (16) erstrecken.

2. Spülgefäss nach Anspruch 1, **dadurch gekennzeichnet, dass** das Ablenkelement (16) die Innenseite der Überlaufschurre (18) bildet.

3. Spülgefäss nach einem der Ansprüche 1 und 2, **dadurch gekennzeichnet, dass** die Seitenflächen (34, 36) einen stumpfen Winkel mit dem durchbrochenen Boden (26) bilden.

4. Spülgefäss nach einem der Ansprüche 1 bis 3, **dadurch gekennzeichnet, dass** die Spritzvorrichtungen von Düsen (32) oder Spritzen (32a) gebildet werden, die im Wesentlichen parallel zu den Seitenflächen (34, 36) ausgerichtet sind.

5. Spülgefäss nach einem der Ansprüche 1 bis 4, **dadurch gekennzeichnet, dass** der Boden (26) der Verteilvorrichtung (12) ein Umlenkelement (42) aufweist, das im mittleren Bereich des Bodens (26) angeordnet ist.

6. Spülgefäss nach Anspruch 5, **dadurch gekennzeichnet, dass** das Umlenkelement (42) eine prismatische Form hat, deren Basis auf dem Boden aufliegt und deren Spitze zu den zu spülenden Gegenständen hin gerichtet ist.

## Claims

1. A rinsing tank for rinsing with ultra clean liquid comprising :
- a rinsing chamber (20) confined by an enclosure (14) equipped at the bottom part with a diffusing device (12) with a perforated base plate (26) connected to a first pressurized liquid supply system (44), and with an overflow spout (18) at the upper part to receive the rinsing liquid charged with particles or contaminants removed from the objects to be rinsed,
- a plurality of projection means (32, 32a) connected to a second pressurized liquid supply system (46), and distributed along the periphery of the perforated base plate (26) of the diffusing device (12),
- means controlling alternately the supply for the projection means (32, 32a) by the second supply system (46) and the supply for the diffusion device (12) by the first supply system (44),
rinsing tank **characterized in that** the rinsing chamber (20) comprises, in addition, a deflector (16) situated at the upper end of the side faces (34, 36) of the enclosure (14), in direction to the central part of the rinsing chamber (20) and forming an obtuse angle with the side faces (34, 36) of the enclosure (14) which extend between the base plate (26) and the deflector.

2. The rinsing tank according to claim 1, **characterized in that** the deflector (16) constitutes the internal face of the overflow spout (18).

3. The rinsing tank according to claims 1 or 2, **characterized in that** the side faces (34, 36) form an obtuse angle with the perforated base plate (26).

4. The rinsing tank according to anyone of claims 1 to 3, **characterized in that** the projection means are formed by nozzles (32) or injectors (32a) directed approximately parallel to side faces (34, 36).

5. The rinsing tank according to anyone of claims 1 to 4, **characterized in that** the base plate (26) of the diffusing device (12) bears a diverting element (42) situated in the central part of the base plate (26).

6. The rinsing tank according to claim 5, **characterized in that** the diverting element (42) presents a prismatic shape having a base resting on the base plate and a peak directed towards the objects to be rinsed.
